(19) Europäisches Patentamt
European Patent Office
Office européen des brevets

(11) EP 3 699 329 A1

(12) EUROPEAN PATENT APPLICATION
published in accordance with Art. 153(4) EPC

(43) Date of publication:
26.08.2020 Bulletin 2020/35

(51) Int Cl.:
C30B 29/04 (2006.01)        B23B 27/14 (2006.01)
B23B 27/20 (2006.01)        C30B 9/10 (2006.01)
C30B 33/02 (2006.01)        C30B 33/04 (2006.01)

(21) Application number: 18868066.4

(22) Date of filing: 29.08.2018

(86) International application number:
PCT/JP2018/031889

(87) International publication number:
WO 2019/077888 (25.04.2019 Gazette 2019/17)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 20.10.2017 JP 2017203413

(71) Applicant: Sumitomo Electric Industries, Ltd.
Osaka-shi, Osaka 541-0041 (JP)

(72) Inventors:
• SUMIYA, Hitoshi
  Osaka-shi
  Osaka 541-0041 (JP)

• HAMAKI, Kensei
  Osaka-shi
  Osaka 541-0041 (JP)
• TERAMOTO, Minori
  Osaka-shi
  Osaka 541-0041 (JP)
• YAMAMOTO, Katsuko
  Osaka-shi
  Osaka 541-0041 (JP)

(74) Representative: Boult Wade Tennant LLP
Salisbury Square House
8 Salisbury Square
London EC4Y 8AP (GB)

(54) **SYNTHETIC SINGLE-CRYSTAL DIAMOND, TOOL, AND PRODUCTION METHOD FOR SYNTHETIC SINGLE-CRYSTAL DIAMOND**

(57) A synthetic single crystal diamond contains nitrogen atoms at a concentration of more than 600 ppm and 1500 ppm or less, and the nitrogen atoms do not include any isolated substitutional nitrogen atom.

FIG.1

**Description**

TECHNICAL FIELD

The present disclosure relates to a synthetic single crystal diamond, a tool and a method of producing a synthetic single crystal diamond. The present application claims the benefit of priority to Japanese Patent Application No. 2017-203413 filed on October 20, 2017, the entire contents of which are incorporated herein by reference.

BACKGROUND ART

Since single crystal diamond has high hardness, it has been widely used in tools such as cutting tools, grinding tools, and anti-wear tools. Single crystal diamond used in tools includes natural diamond and synthetic diamond.

Most of the natural diamonds (type Ia diamond) contain aggregated nitrogen atoms as impurities. Aggregated nitrogen atoms in the diamond crystal can inhibit the plastic deformation and/or the development of cracks when the diamond is used in a tool. Therefore, natural diamond has high mechanical strength. However, since natural diamond varies greatly in quality and the supply thereof is not stable, there is a great risk in using natural diamond in the industrial field.

On the contrary, synthetic diamond is constant in quality and may be supplied stably, and thereby is widely used in the industrial field.

Generally, synthetic diamond (type Ib diamond) contains isolated substitutional nitrogen atoms as impurities. It is known that the mechanical properties of diamond will deteriorate as the concentration of isolated substitutional nitrogen atoms in diamond crystals increases. Therefore, when type Ib synthetic diamond is used in a tool, the cutting edge thereof is likely to be worn or chipped off.

Further, some synthetic diamonds (type IIa diamond) contain almost no nitrogen impurities. Since type IIa synthetic diamond does not contain impurities or crystal defects that can inhibit the progress of cracks, when it is used in a tool, the cutting edge of the tool is likely to be chipped off.

Therefore, studies have been carried out on techniques for improving wear resistance and chipping resistance in synthetic diamonds.

For example, PTL 1 (Japanese Patent Laying-Open No. 2015-134718) discloses a technique for improving the toughness and wear resistance of a diamond by irradiating type Ib synthetic diamond material with an electron beam or a neutron beam to form isolated vacancy defects in the diamond material and annealing the diamond material thereafter.

Also, NPL 1 (A T Collins, Vacancy enhanced aggregation of nitrogen in diamond, Journal of Physics C: Solid State Physics, the Institute of Physics, UK, 1980, No. 13, p 2641-50) discloses a technique in which after type Ib synthetic diamond material is irradiated with an electron beam, a heat treatment is performed to convert isolated substitutional nitrogen atoms in the crystal into aggregated nitrogen atoms.

CITATION LIST

PATENT LITERATURE

PTL 1: Japanese Patent Laying-Open No. 2015-134718

NON PATENT LITERATURE

NPL 1: A T Collins, Vacancy enhanced aggregation of nitrogen in diamond, Journal of Physics C: Solid State Physics, the Institute of Physics, UK, 1980, No. 13, p 2641-50

SUMMARY OF INVENTION

A synthetic single crystal diamond according to an aspect of the present disclosure contains nitrogen atoms at a concentration of more than 600 ppm and 1500 ppm or less, and the nitrogen atoms do not include any isolated substituted nitrogen atom.

A synthetic single crystal diamond according to another aspect of the present disclosure contains nitrogen atoms at a concentration of more than 600 ppm and 1500 ppm or less, and an absorption peak derived from isolated substitutional nitrogen atoms is absent in the wave number range of $1130 \pm 2$ cm$^{-1}$ in an infrared absorption spectrum measured by Fourier transform infrared spectroscopy.

A tool according to an aspect of the present disclosure includes the synthetic single crystal diamond mentioned above.

A method of producing a synthetic single crystal diamond according to an aspect of the present disclosure includes: obtaining a diamond single crystal containing nitrogen atoms at a concentration of more than 600 ppm and 1500 ppm or less by a temperature difference process using a solvent metal; irradiating the diamond single crystal with one or both of an electron beam and a particle beam so as to apply an energy of 100 MGy or more and 1000 MGy or less to the diamond single crystal; and annealing the irradiated diamond single crystal at a temperature of 1700°C or higher and 1800°C or lower under normal pressure.

BRIEF DESCRIPTION OF DRAWINGS

Fig. 1 is a diagram illustrating an infrared absorption spectrum of a synthetic single crystal diamond; and
Fig. 2 is a cross-sectional view schematically illustrating an example configuration of a sample chamber used for producing a synthetic single crystal diamond according to an aspect of the present disclosure.

DETAILED DESCRIPTION

[Problem to be Solved by the Present Disclosure]

PTL 1 and NPL 1 both relate to the techniques for converting isolated substitutional nitrogen atoms in type Ib synthetic diamond into aggregated nitrogen atoms, but the conversion rate is insufficient, which makes the hardness and the chipping resistance of the obtained synthetic diamond insufficient.
Therefore, an object of the present disclosure is to provide a synthetic single crystal diamond having high hardness and excellent chipping resistance, a tool including a synthetic single crystal diamond and a method of producing a synthetic single crystal diamond.

[Advantageous Effect of the Present Disclosure]

According to the above aspects, there is provided a synthetic single crystal diamond having high hardness and excellent chipping resistance, a tool including a synthetic single crystal diamond and a method of producing a synthetic single crystal diamond.

[Description of Aspects]

First, a description will be given on each aspect of the present disclosure.

(1) A synthetic single crystal diamond according to an aspect of the present disclosure contains nitrogen atoms at a concentration of more than 600 ppm and 1500 ppm or less, and the nitrogen atoms do not include any isolated substituted nitrogen atom.
(2) A synthetic single crystal diamond according to another aspect of the present disclosure contains nitrogen atoms at a concentration of more than 600 ppm and 1500 ppm or less, and an absorption peak derived from isolated substitutional nitrogen atoms is absent in the wave number range of $1130 \pm 2$ cm$^{-1}$ in an infrared absorption spectrum measured by Fourier transform infrared spectroscopy.
Since the synthetic single crystal diamond according to the aspect (1) or (2) has high hardness and excellent chipping resistance because it does not contain any isolated substituted nitrogen atom.
(3) The synthetic single crystal diamond preferably has a cracking load of 12 N or more in a breaking strength test in which a spherical diamond indenter having a tip radius of 50 $\mu$m is pressed against a surface of the synthetic single crystal diamond at a loading speed of 100 N/min. When the cracking load is 12 N or more, the synthetic single crystal diamond has excellent breaking strength and chipping resistance, and when it is used as a material in a cutting tool, the cutting tool may cut any difficult-to-cut hard material without causing the chipping of the cutting edge.
(4) The synthetic single crystal diamond preferably has a Knoop hardness of 100 GPa or more in the <100> direction on the {001} plane. When the synthetic single crystal diamond having this hardness is used as a material in a tool, the wear resistance of the tool is improved.
(5) A tool according to an aspect of the present disclosure includes the synthetic single crystal diamond described in any of the above aspects (1) to (4). Therefore, the tool has high hardness and excellent chipping resistance.
(6) A method of producing a synthetic single crystal diamond according to an aspect of the present disclosure includes: obtaining a diamond single crystal containing nitrogen atoms at a concentration of more than 600 ppm and 1500 ppm or less by a temperature difference process using a solvent metal; irradiating the diamond single crystal with one or both of an electron beam and a particle beam so as to apply an energy of 100 MGy or more and 1000 MGy or less to the diamond single crystal; and annealing the irradiated diamond single crystal at a temperature of 1700°C or higher and 1800°C or lower under normal pressure.

According to the method of producing a synthetic single crystal diamond according to an aspect of the present disclosure, it is possible to obtain the synthetic single crystal diamond described above in the aspect (1) or (2).

[Details of Embodiments of the Present Disclosure]

Specific examples of a synthetic single crystal diamond, a tool and a method of producing a synthetic single crystal diamond according to an embodiment of the present disclosure will be described below with reference to the drawings. It is intended that the scope of the present disclosure is not limited to the description above but defined by the scope of the claims and encompasses all modifications equivalent in meaning and scope to the claims.

<Synthetic Single Crystal Diamond>

A synthetic single crystal diamond according to an embodiment of the present disclosure contains nitrogen atoms at a concentration of more than 600 ppm and 1500 ppm or less, and the nitrogen atoms do not include any isolated substituted nitrogen atom.

A synthetic single crystal diamond according to another embodiment of the present disclosure contains nitrogen atoms at a concentration of more than 600 ppm and 1500 ppm or less, and an absorption peak derived from isolated substitutional nitrogen atoms is absent in the wave number range of $1130\pm2$ cm$^{-1}$ in an infrared absorption spectrum measured by Fourier transform infrared spectroscopy.

Nitrogen atoms present as impurities in the crystal serve as one of the main factors for determining the quality of a diamond. Nitrogen atoms in a single crystal diamond may be classified into isolated substitutional nitrogen atoms, aggregated nitrogen atoms and the like, depending on the form of existence. Hereinafter, isolated substitutional nitrogen atoms and aggregated nitrogen atoms will be described.

Isolated substitutional nitrogen atoms refer to those atoms that each replaces a carbon atom in a diamond crystal and exists at the position of the carbon atom as an atomic unit. Diamonds containing isolated substitutional nitrogen atoms are divided into type Ib diamond, type IIa diamond and type IIb diamond. Isolated substitutional nitrogen atoms do not greatly affect the crystal structure of the single crystal diamond, and therefore will not contribute to the suppression of crack propagation.

A synthetic single crystal diamond containing isolated substitutional nitrogen atoms shows a peak near the wave number of 1130 cm$^{-1}$ (i.e., $1130\pm2$ cm$^{-1}$) in the infrared absorption spectrum measured by Fourier transform infrared spectroscopy.

In a synthetic single crystal diamond containing isolated substituted nitrogen atoms, the nitrogen atoms exist as unpaired electrons, and thereby, the concentration of isolated substituted nitrogen atoms may be measured by ESR (Electron Spin Resonance) analysis. In addition to isolated substitutional nitrogen atoms, the ESR analysis may also detect signals for crystal defects containing unpaired electrons. In this case, isolated substitutional nitrogen atoms may be identified separately by its g value or its signal relaxation time.

Aggregated nitrogen atoms refer to those atoms that are present in a diamond crystal in an aggregate of two or more nitrogen atoms. Unlike isolated substitutional nitrogen atoms, aggregated nitrogen atoms can suppress the propagation of cracks in a single crystal diamond. Aggregated nitrogen atoms may be further classified into categories such as 2-nitrogen atom pairs, 4-nitrogen atom aggregates and platelets.

A 2-nitrogen atom pair is one in which two nitrogen atoms are covalently bonded and replace corresponding carbon atoms. A diamond containing 2-nitrogen atom pairs is called type IaA diamond. A synthetic single crystal diamond containing 2-nitrogen atom pairs shows a peak near the wave number of 1280 cm$^{-1}$ (i.e., $1280\pm2$ cm$^{-1}$) in the infrared absorption spectrum measured by Fourier transform infrared spectroscopy.

A 4-nitrogen atom aggregate is one in which four nitrogen atoms are present adjacent to one vacancy and replace corresponding carbon atoms. A diamond containing 4-nitrogen atom aggregates is called type IaB diamond. A synthetic single crystal diamond containing 4-nitrogen atom aggregates shows a peak near the wave number of 1175 cm$^{-1}$ (i.e., $1175\pm2$ cm$^{-1}$) in the infrared absorption spectrum measured by Fourier transform infrared spectroscopy.

The platelet is one in which five or more nitrogen atoms are aggregated and replace corresponding carbon atoms. A diamond containing platelets is called type IaB' diamond. A synthetic single crystal diamond containing plates shows a peak near the wave number of 1365 cm$^{-1}$ (i.e., $1365\pm10$ cm$^{-1}$) in the infrared absorption spectrum measured by Fourier transform infrared spectroscopy.

When all of the nitrogen atoms in the synthetic single crystal diamond are aggregated nitrogen atoms, there are no unpaired electrons in the synthetic single crystal diamond. Therefore, such synthetic single crystal diamond does not show absorption when it is subjected to the ESR analysis.

Since the nitrogen atoms in the synthetic single crystal diamond do not include isolated substitutional nitrogen atoms that contribute nothing to the suppression of crack propagation, the synthetic single crystal diamond according to the present embodiment has excellent chipping resistance.

Whether or not the synthetic single crystal diamond contains isolated substitutional nitrogen atoms may be determined from the infrared absorption spectrum measured by Fourier transform infrared spectroscopy. Single crystal diamond containing isolated substitutional nitrogen atoms shows a peak near the wave number of 1130 $cm^{-1}$ (i.e., 1130$\pm$2 $cm^{-1}$) in an infrared absorption spectrum measured by Fourier transform infrared spectroscopy. Therefore, it may be determined that the synthetic single crystal diamond does not contain isolated substitutional nitrogen atoms by confirming that an absorption peak derived from isolated substitutional nitrogen atoms is absent in the wave number range of 1130$\pm$2$cm^{-1}$ in the infrared absorption spectrum of the synthetic single crystal diamond.

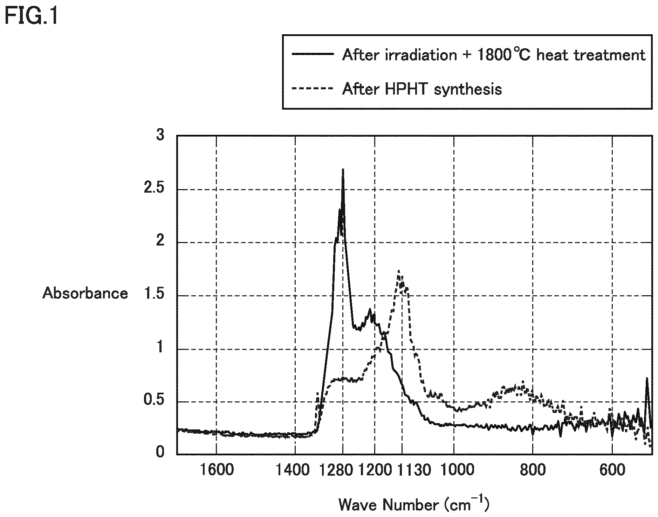

An infrared absorption spectrum of the synthetic single crystal diamond according to the present embodiment will be described with reference to an example in Fig. 1. In Fig. 1, a broken line illustrates an infrared absorption spectrum of a diamond single crystal which contains isolated substitutional nitrogen atoms and is synthesized by a high-pressure high-temperature (HPHT) synthesis method, and a solid line illustrates an infrared absorption spectrum of a synthetic single crystal diamond containing no isolated substitutional nitrogen atom, which is obtained by subjecting the diamond single crystal illustrated by the broken line to electron beam irradiation and heat treatment at 1800°C. Note that in both the diamond single crystal and the synthetic single crystal diamond, the concentration of nitrogen atoms is 1000 ppm.

As illustrated in Fig. 1 by the solid line, in the infrared absorption spectrum of the synthetic single crystal diamond containing no isolated substitutional nitrogen atom, no absorption peak is present in the wave number range of 1130$\pm$2 $cm^{-1}$. On the contrary, as illustrated in Fig. 1 by the broken line, in the infrared absorption spectrum of the diamond single crystal containing isolated substitutional nitrogen atoms, an absorption peak appears in the wave number range of 1130$\pm$2 $cm^{-1}$. As illustrated in Fig. 1 by the solid line, since an absorption peak is present in the wave number range of 1280$\pm$2 $cm^{-1}$, it may be determined that the synthetic single crystal diamond contains 2-nitrogen atom pairs.

In the infrared absorption spectrum, if there is a shoulder in the wave number range of 1130$\pm$2 $cm^{-1}$ and it is unclear whether the shoulder is an absorption peak derived from isolated substitutional nitrogen atoms, the presence or absence of isolated substitutional nitrogen atoms may be determined by the ESR analysis. When there is no isolated substitutional nitrogen atom in the synthetic single crystal diamond, there are no unpaired electrons in the synthetic single crystal diamond. Therefore, when the ESR analysis is performed, no signal is detected from the synthetic single crystal diamond. As a result, it may be confirmed that there is no isolated substitutional nitrogen atom in the synthetic single crystal diamond.

In the infrared absorption spectrum of the synthetic single crystal diamond, a peak derived from 2-nitrogen atom pairs may appear in the wave number range of 1280$\pm$2 $cm^{-1}$. Further, a peak derived from 4-nitrogen atom aggregates may be present in the wave number range of 1175$\pm$2 $cm^{-1}$. Furthermore, a peak derived from platelets may appear in the wave number range of 1365$\pm$10 $cm^{-1}$. Aggregated nitrogen atoms can suppress the propagation of cracks in single crystal diamond. Therefore, such synthetic single crystal diamond may have excellent chipping resistance.

The synthetic single crystal diamond according to the present embodiment contains nitrogen atoms at a concentration of more than 600 ppm and 1500 ppm or less. Here, the concentration of nitrogen atoms is the concentration of nitrogen atoms in the synthetic single crystal diamond in terms of atom numbers. The concentration of nitrogen atoms in the synthetic single crystal diamond may be measured by SIMS (Secondary Ion Mass Spectrometry). When the concentration of nitrogen atoms is 600 ppm or less, the nitrogen atoms hardly aggregate with each other, and the tendency for isolated substitutional nitrogen atoms to be present in the synthetic single crystal diamond increases, which makes the hardness and chipping resistance of the synthetic single crystal diamond insufficient. On the contrary, when the concentration of nitrogen atoms exceeds 1500 ppm, lattice defects in the synthetic single crystal diamond increase, which makes the hardness and chipping resistance of the synthetic single crystal diamond insufficient. The concentration of nitrogen atoms in the synthetic single crystal diamond is more preferably 620 ppm or more and 1200 ppm or less, and further preferably 650 ppm or more and 1000 ppm or less.

Preferably, the synthetic single crystal diamond has a cracking load of 12 N or more in a breaking strength test in which a spherical diamond indenter having a tip radius (R) of 50 $\mu$m is pressed against a surface of the synthetic single crystal diamond at a loading speed of 100 N/min. When the cracking load is 12 N or more, the synthetic single crystal diamond has excellent breaking strength and chipping resistance, and when it is used as a material in a cutting tool, the cutting tool may cut any difficult-to-cut hard material without causing the chipping of the cutting edge. The cracking load is more preferably 15N or more, and further preferably 18 N or more. The upper limit of the cracking load is not particularly limited, but from the viewpoint of production, it is preferably 50 N or less.

The breaking strength test is performed under the following conditions. A spherical diamond indenter with a tip radius (R) of 50 $\mu$m is pressed against the sample, a load is applied to the sample at a loading speed of 100 N/min, and the load at the moment when a crack occurs in the sample (cracking load) is measured. The moment when a crack occurs is measured using an AE sensor. The larger the cracking load, the higher the hardness of the sample and the better the chipping resistance. When an indenter with a tip radius (R) smaller than 50 μm is used as the measuring indenter, the sample is plastically deformed before a crack is generated, and the strength against cracks may not be measured accurately. On the contrary, an indenter with a tip radius (R) larger than 50 μm may be used to perform the measurement, but in this case, a greater load is required until a crack occurs and the contact area between the indenter and the sample increases, which may affect the measurement accuracy due to the surface accuracy of the sample and may greatly affect the crystal orientation of the crystal. Therefore, it is preferable to use an indenter with a tip radius (R) of 50 μm in the breaking strength test for a synthetic single crystal diamond.

The synthetic single crystal diamond according to the present embodiment preferably has a Knoop hardness of 100 GPa or more in the <100> direction on the {001} plane. In the present specification, a generic plane orientation including any crystallographically equivalent plane orientation is indicated by { }, and a generic direction including any crystallographically equivalent direction is indicated by <>. A synthetic single crystal diamond having a Knoop hardness of 100 GPa or more has higher hardness and superior wear resistance than natural diamond containing nitrogen. The Knoop hardness is more preferably 110 GPa or more and 130 GPa or less.

A method of calculating the Knoop hardness (hereinafter also referred to as HK having a unit of GPa) will be described. First, an indentation is made with a load F (N) in the <100> direction on the {001} plane of a synthetic single crystal diamond. The width "a" (μm) of the indentation is measured, and the Knoop hardness (HK) is calculated by the following expression (1).

$$HK = 14229 \times F/a^2 \qquad (1)$$

The synthetic single crystal diamond according to the present embodiment includes, as inclusions, at least one element selected from the group consisting of titanium (Ti), vanadium (V), chromium (Cr), manganese (Mn), iron (Fe), nickel (Ni), cobalt (Co), copper (Cu), Zirconium (Zr), niobium (Nb), molybdenum (Mo), ruthenium (Ru), rhodium (Rh), palladium (Pd), hafnium (Hf), tantalum (Ta), tungsten (W), osmium (Os), iridium (Ir) and platinum (Pt); at least one alloy containing two or more elements selected from the group; a compound composed of at least one element selected from the group and carbon (C) or oxygen (O); and at least one selected from the group consisting of composites containing at least one element, at least one alloy and the compound.

If the density or the size of the inclusions is large, the synthetic single crystal diamond bonded to a polishing substrate may be damaged due to the thermal expansion difference between the synthetic single crystal diamond and the polishing substrate, which may be a problem in practical use. Therefore, the density of the inclusions in the synthetic single crystal diamond is preferably 20 pieces/mm$^3$ or less, and more preferably 10 pieces/mm$^3$ or less. Further, the inclusion may preferably have a span diameter of 10 μm or less, and more preferably 5 μm or less. The span diameter refers to the maximum length of a straight line that can be drawn in a single crystal having a certain size and a certain shape. Most preferably, the synthetic single crystal diamond does not contain any inclusions.

<Tool>

The synthetic single crystal diamond according to an embodiment of the present disclosure has high hardness and excellent chipping resistance and is stable in quality, which makes it applicable in various applications. For example, the synthetic single crystal diamond can be used as a material for a wear-resistant tool such as a dresser, a wire drawing die, a scribe tool or a water jet orifice, or for a cutting tool such as a precision cutting tool or a wood cutter. A tool containing the synthetic single crystal diamond according to an embodiment of the present disclosure can perform stable processing for a longer time and thereby has a longer tool life than a tool produced from a conventional synthetic diamond, natural diamond or a diamond sintered body.

<Method of Producing Synthetic Single Crystal Diamond>

A method of producing a synthetic single crystal diamond according to an embodiment of the present disclosure includes: obtaining a diamond single crystal containing nitrogen atoms at a concentration of more than 600 ppm and 1500 ppm or less by a temperature difference process using a solvent metal (hereinafter also referred to as a temperature difference step); irradiating the diamond single crystal with one or both of an electron beam and a particle beam having an energy of 100 MGy or more and 1000 MGy or less (hereinafter also referred to as an irradiation step); and annealing the irradiated diamond single crystal at a temperature of 1700°C or higher and 1800°C or lower under normal pressure (hereinafter, also referred to as an annealing step).

(Temperature Difference Step)

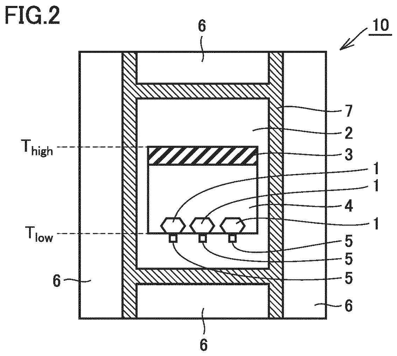

A diamond single crystal may be produced by a temperature difference process in a sample chamber having a configuration illustrated in Fig. 2, for example.

As illustrated in Fig. 2, in a sample chamber 10 used for the production of the diamond single crystal, an insulator 2, a carbon source 3, a solvent metal 4 and seed crystals 5 are disposed in a space surrounded by a graphite heater 7, and a pressure medium 6 is disposed outside the graphite heater 7. The temperature difference process is a synthesis process in which a temperature gradient in the vertical direction is provided inside the sample chamber 10, the carbon source 3 is disposed in a high temperature portion ($T_{high}$) and the seed crystals 5 are disposed in a low temperature portion ($T_{low}$), the solvent metal 4 is disposed between the carbon source 3 and the seed crystals 5, and a diamond single crystal is grown on each of the seed crystals 5 by maintaining the temperature equal to or high than a temperature at which the solvent metal 4 is dissolved and the pressure equal to or high than a pressure at which the diamond is thermally stable.

As the carbon source 3, diamond powder is preferably used. In addition, graphite (black lead) or pyrolytic carbon may also be used. As the solvent metal 4, at least one metal selected from iron (Fe), cobalt (Co), nickel (Ni), manganese (Mn) and the like, or an alloy containing these metals may be used.

The carbon source 3 or the solvent metal 4 may include a nitrogen source which is added as a simple substance or a mixture of, for example, a nitride such as iron nitride ($Fe_2N$, $Fe_3N$), aluminum nitride (AlN), phosphorus nitride ($P_3N_4$) or silicon nitride ($Si_3N_4$), or an organic nitrogen compound such as melamine or sodium azide. Thereby, the synthesized diamond single crystal may contain nitrogen atoms, and the nitrogen atoms in the diamond single crystal exist mainly as isolated substitutional nitrogen atoms.

The content of the nitrogen source in the carbon source 3 or the solvent metal 4 may be adjusted so that the concentration of nitrogen atoms in the synthesized diamond single crystal is more than 600 ppm and 1500 ppm or less. For example, in the carbon source, the content of nitrogen atoms derived from the nitrogen source may be adjusted to 200 ppm or more and 3000 ppm or less. In the case of the solvent metal, for example, when the solvent metal is an alloy composed of iron, cobalt and nickel and the nitrogen source is Fe3N, the content of the nitrogen source may be adjusted to 0.08 mass% or more and 0.2 mass% or less.

The solvent metal 4 may further contain at least one element selected from the group consisting of titanium (Ti), vanadium (V), chromium (Cr), manganese (Mn), copper (Cu), zirconium (Zr), niobium (Nb), molybdenum (Mo), ruthenium (Ru), rhodium (Rh), hafnium (Hf), tantalum (Ta), tungsten (W), osmium (Os), iridium (Ir), and platinum (Pt).

(Irradiation Step)

Next, the obtained diamond single crystal is irradiated with one or both of an electron beam and a particle beam with an energy of 100 MGy or more and 1000 MGy or less. As a result, lattice defects are introduced into the diamond single crystal, and thereby vacancies are formed.

If the amount of irradiation energy is less than 100 MGy, the introduction of lattice defects may be insufficient. On the contrary, if the amount of energy is greater than 1000 MGy, excessive vacancies may be formed, which may greatly deteriorate the crystallinity. Therefore, the amount of energy is preferably 100 MGy or more and 1000 MGy or less.

As the particle beam, a neutron beam or a proton beam may be used. The irradiation conditions are not particularly limited as long as the amount of energy applied to the diamond single crystal is 100 MGy or more and 1000 MGy or less. For example, in the case of using an electron beam, the irradiation energy may be 4.6 MeV or more and 4.8 MeV or less, the current may be 2 mA or more and 5 mA or less, and the irradiation time may be 30 hours or more and 45 hours or less.

(Annealing Step)

Next, the diamond single crystal irradiated with the particle beam is annealed at a temperature of 1700°C or higher and 1800°C or lower in vacuum or in an inert gas atmosphere under normal pressure. Thereby, the isolated substitutional nitrogen atoms in the diamond single crystal move through the vacancies and aggregate with each other to form aggregated nitrogen atoms.

If the annealing temperature is lower than 1700°C, the aggregation speed of nitrogen atoms is slow, and the annealing treatment is required to be performed for a longer time, which is not preferable. On the contrary, if the annealing temperature is higher than 1800°C, the aggregation speed of nitrogen atoms increases, but the diamond single crystal will be graphitized under normal pressure. Therefore, when the annealing treatment is performed at a temperature higher than 1800°C, it must be performed under ultra-high pressure where the diamond is thermodynamically stable, which is not preferable from the consideration of an increase in costs or a decrease in productivity. Accordingly, the annealing temperature is preferably 1700°C or higher and 1800°C or lower.

The particle beam irradiation step and the annealing step each may be performed once as one cycle, and the cycle may be repeated twice or more, which may promote the aggregation of isolated substitutional nitrogen atoms in the diamond single crystal. By performing the particle beam irradiation step and the annealing step sufficiently, all the isolated substitutional nitrogen atoms in the diamond single crystal may be converted into the aggregated nitrogen atoms. Thus, no isolated substitutional nitrogen atom is present in the obtained synthetic single crystal diamond, all the nitrogen atoms are present as the aggregated nitrogen atoms.

[Examples]

The present disclosure will be described in more detail with reference to examples. However, the scope of the present disclosure is not limited to these examples.

<Production of Synthetic Single Crystal Diamond>

[Sample 1]

(Temperature Difference Step)

First, a diamond single crystal was synthesized in a sample chamber having the configuration illustrated in Fig. 2 by the temperature difference process using a solvent metal.
As the solvent metal, an alloy composed of iron, cobalt and nickel was prepared, and to the solvent metal, iron nitride ($Fe_3N$) powder was added as a nitrogen source. The concentration of iron nitride in the solvent metal was 0.08 mass%.
Diamond powder was used as the carbon source, and about 0.5 mg of diamond single crystal was used as the seed crystal. The temperature in the sample chamber was adjusted by using a heater so that a temperature difference of several tens of degrees was created between the high temperature portion where the carbon source was disposed and the low temperature portion where the seed crystal was disposed. In addition, a ultrahigh pressure generator was used to control the pressure to 5.5 GPa and the temperature of the low temperature portion in the range of 1370°C±10°C (1360°C to 1380°C), and the controlled pressure and temperature were kept for 60 hours, and thereby the diamond single crystal was synthesized on the seed crystal.

(Irradiation Step)

Next, the obtained diamond single crystal was irradiated with an electron beam. The irradiation condition was set to include an irradiation energy of 4.6 MeV, a current of 2 mA, and an irradiation time of 30 hours. This irradiation condition is the same as the irradiation condition for applying an energy of 100 MGy to a diamond single crystal.

(Annealing Step)

Next, the diamond single crystal after the electron beam irradiation was annealed at a temperature of 1700°C for 1 hour in vacuum under normal pressure, and thereby a synthetic single crystal diamond was obtained.

[Samples 2 to 12]

(Temperature Difference Step)

Diamond single crystals were produced for samples 2 to 12 by the temperature difference step in the same manner as sample 1. The difference between samples 2 to 12 and sample 1 is the amount of iron nitride ($Fe_3N$) powder added to the solvent metal, i.e., the concentration of iron nitride in the solvent metal listed in the column "concentration of iron nitride in solvent metal" in Table 1.

(Irradiation Step)

The diamond single crystals for samples 2 to 5 and 7 to 9 were irradiated with the electron beam under the same irradiation conditions as sample 1. The diamond single crystals for samples 6 and 10 to 14 were not irradiated with the electron beam.

(Annealing Step)

After the irradiation step, the diamond single crystals for samples 2 to 5, 7 to 9, 11 and 12 were subjected to the annealing step for 1 hour at respective temperatures listed in the column "annealing temperature" in Table 1 to obtain the synthetic single crystal diamond. The diamond single crystals for samples 6 and 10 were not subjected to the annealing step.

The diamond single crystal for sample 4 was subjected to the electron beam irradiation step and the annealing step in this order for two times (two cycles). Samples 1 to 5 correspond to examples, and samples 6 to 12 correspond to comparative examples.

Table 1

| | Temperature Difference Step | Irradiation energy (MGy) | Annealing Conditions | | Synthetic Single Crystal Diamond | | | |
| | Iron nitride concentration in solvent metal (mass%) | | Temperature (°C) | Time (h) | Nitrogen concentration (ppm) | Absorption peak (1130±2cm⁻¹) | Hardness (GPa) | Cracking load (N) |
|---|---|---|---|---|---|---|---|---|
| Sample 1 | 0.08 | 100 | 1700 | 1 | 650 | NO | 105 | 12 |
| Sample 2 | 0.08 | 100 | 1800 | 1 | 650 | NO | 107 | 15 |
| Sample 3 | 0.11 | 100 | 1700 | 1 | 850 | NO | 110 | 17 |
| Sample 4 | 0.12 | 100 (2 times) | 1700 | 1 (2 times) | 950 | NO | 120 | 18 |
| Sample 5 | 0.13 | 100 | 1800 | 1 | 1000 | NO | 122 | 20 |
| Sample 6 | 0 | No irradiation | No annealing | | 60 | YES | 85 | 8 |
| Sample 7 | 0 | 100 | 1700 | 1 | 60 | YES | 87 | 10 |
| Sample 8 | 0 | 100 | 1800 | 1 | 60 | YES | 90 | 10 |
| Sample 9 | 0.06 | 100 | 1700 | 1 | 480 | YES | 90 | 10 |
| Sample 10 | 0.09 | No irradiation | No annealing | | 700 | YES | 77 | 4 |
| Sample 11 | 0.09 | No irradiation | 1700 | 1 | 700 | YES | 95 | 8 |
| Sample 12 | 0.09 | No irradiation | 1800 | 1 | 700 | YES | 97 | 10 |

<Evaluation of Synthetic Single Crystal Diamond>

The obtained synthetic single crystal diamond was subjected to measurement of nitrogen concentration, infrared spectroscopy, Knoop hardness measurement, and breaking strength test.

(Determination of Nitrogen Concentration)

The nitrogen concentration in the synthetic single crystal diamond of each sample was determined by SIMS analysis. The results are listed in Table 1.

(Infrared Spectroscopy)

After machining the synthetic single crystal diamond of each sample into a plate with a thickness of about 1 mm and polishing two surfaces that transmit light to mirror surfaces, the absorbance is measured in the infrared region with a Fourier transform infrared spectrophotometer to prepare an infrared absorption spectrum. In the infrared absorption spectrum, it was confirmed whether or not an absorption peak derived from isolated substitutional nitrogen atoms is present in the wave number range of $1130\pm2$ cm$^{-1}$. The results are listed in Table 1. In Table 1, when the infrared absorption peak is present, it is denoted as "YES", and when the infrared absorption peak is not present, it is denoted as "No".

(Measurement of Knoop Hardness)

The Knoop hardness was obtained in the following manner: an indentation was made with a load of 4.9 N in the < 100> direction on the {001} plane of the synthetic single crystal diamond, the width "a" of the indentation was measured, and the Knoop hardness (HK) was calculated by the following expression (2). The results are listed in Table 1.

$$HK = 14229 \times 4.9/a^2 \qquad (2)$$

(Breaking Strength Test)

A spherical diamond indenter having a tip radius R of 50 $\mu$m was prepared, a load was applied to each sample at a loading speed of 100 N/min at room temperature (23°C), and the load at the moment when a crack occurred in the sample (cracking load) was measured. The moment when the crack occurred was measured using an AE sensor. The larger the cracking load, the higher the strength of the sample and the better the chipping resistance. The results are listed in Table 1.

The synthetic single crystal diamonds of samples 1 to 5 contain nitrogen atoms at a concentration of more than 600 ppm and 1500 ppm or less, and an absorption peak derived from isolated substitutional nitrogen atoms is absent in the wave number range of $1130\pm2$ cm$^{-1}$ in an infrared absorption spectrum measured by Fourier transform infrared spectroscopy. These synthetic single crystal diamonds have high hardness and excellent chipping resistance.

The synthetic single crystal diamonds of samples 6 to 9 contain nitrogen atoms at a concentration of more than 60 ppm and 480 ppm or less, and an absorption peak derived from isolated substitutional nitrogen atoms is present in the wave number range of $1130\pm2$ cm$^{-1}$. These synthetic single crystal diamonds have insufficient hardness and insufficient chipping resistance.

The synthetic single crystal diamonds of samples 10 to 12 contain nitrogen atoms at a concentration of 700 ppm, and an absorption peak derived from isolated substitutional nitrogen atoms is present in the wave number range of $1130\pm2$ cm$^{-1}$. These synthetic single crystal diamonds have insufficient hardness and insufficient chipping resistance.

It should be understood that the embodiments and examples disclosed herein have been presented for the purpose of illustration and description but not limited in all aspects. It is intended that the scope of the present disclosure is not limited to the description above but defined by the scope of the claims and encompasses all modifications equivalent in meaning and scope to the claims.

REFERENCE SIGNS LIST

1: single crystal diamond; 2: insulator; 3: carbon source; 4: solvent metal; 5: seed crystal; 6: pressure medium; 7: graphite heater

**Claims**

1. A synthetic single crystal diamond containing nitrogen atoms at a concentration of more than 600 ppm and 1500 ppm or less,
   the nitrogen atoms including no isolated substituted nitrogen atom.

2. A synthetic single crystal diamond containing nitrogen atoms at a concentration of more than 600 ppm and 1500 ppm or less,
   an absorption peak derived from isolated substitutional nitrogen atoms being absent in the wave number range of $1130 \pm 2$ cm$^{-1}$ in an infrared absorption spectrum measured by Fourier transform infrared spectroscopy.

3. The synthetic single crystal diamond according to claim 1 or 2, wherein the synthetic single crystal diamond has a cracking load of 12 N or more in a breaking strength test in which a spherical diamond indenter having a tip radius of 50 $\mu$m is pressed against a surface of the synthetic single crystal diamond at a loading speed of 100 N/min.

4. The synthetic single crystal diamond according to any one of claims 1 to 3, wherein the synthetic single crystal diamond has a Knoop hardness of 100 GPa or more in a <100> direction on a {001} plane.

5. A tool including the synthetic single crystal diamond according to any one of claims 1 to 4.

6. A method of producing a synthetic single crystal diamond comprising:

   obtaining a diamond single crystal containing nitrogen atoms at a concentration of more than 600 ppm and 1500 ppm or less by a temperature difference process using a solvent metal;
   irradiating the diamond single crystal with one or both of an electron beam and a particle beam so as to apply an energy of 100 MGy or more and 1000 MGy or less to the diamond single crystal; and
   annealing the irradiated diamond single crystal at a temperature of 1700°C or higher and 1800°C or lower under normal pressure.

FIG.1

FIG.2

## INTERNATIONAL SEARCH REPORT

International application No.

PCT/JP2018/031889

**A. CLASSIFICATION OF SUBJECT MATTER**
Int. Cl. C30B29/04(2006.01)i, B23B27/14(2006.01)i, B23B27/20(2006.01)i,
C30B9/10(2006.01)i, C30B33/02(2006.01)i, C30B33/04(2006.01)i

According to International Patent Classification (IPC) or to both national classification and IPC

**B. FIELDS SEARCHED**

Minimum documentation searched (classification system followed by classification symbols)
Int. Cl. C30B29/04, B23B27/14, B23B27/20, C30B9/10, C30B33/02, C30B33/04

Documentation searched other than minimum documentation to the extent that such documents are included in the fields searched
Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)
JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| Y | WO 2016/068244 A1 (SUMITOMO ELECTRIC INDUSTRIES, LTD.) 06 May 2016, paragraphs [0017]-[0087] & US 2017/0314159 A1, paragraphs [0014]-[0104] & EP 3214208 A1 & KR 10-2017-0074973 A & CN 107109690 A | 1-5 |
| Y | JP 53-25292 A (GENERAL ELECTRIC CO.) 08 March 1978, page 4, lower left column, line 16 to page 8, lower right column, line 5 & US 4174380 A1, column 6, line 49 to column 9, line 20 & DE 2732793 A & FR 2359071 A | 1-5 |

☒ Further documents are listed in the continuation of Box C.    ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30.10.2018 | 13.11.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

| | International application No. |
|---|---|
| | PCT/JP2018/031889 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2016-164102 A (SUMITOMO ELECTRIC INDUSTRIES, LTD.) 08 September 2016, paragraphs [0077]-[0087], tables 1, 2 & US 2018/0079010 A1, paragraphs [0094]-[0103] & EP 3266756 A1 & CN 107406334 A | 3 |
| Y | WO 2012/023473 A1 (SUMITOMO ELECTRIC INDUSTRIES, LTD.) 23 February 2012, paragraphs [0033]-[0048] & US 2012/0258035 A1, paragraphs [0037]-[0051] & EP 2607307 A1 & CN 102712478 A | 4 |
| A | JP 2015-134718 A (ELEMENT SIX LIMITED) 27 July 2015, paragraphs [0031]-[0048] & US 2013/0192144 A1, paragraphs [0051]-[0064] & CN 102939261 A & KR 10-2013-0031316 A | 6 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017203413 A

- JP 2015134718 A

**Non-patent literature cited in the description**

- **A T COLLINS.** Vacancy enhanced aggregation of nitrogen in diamond. *Journal of Physics C: Solid State Physics, the Institute of Physics,* 1980, 2641-50